# EUROPEAN PATENT SPECIFICATION

(11) **EP 1 375 702 B1**
(45) Date of publication and mention of the grant of the patent: **30.03.2011**
(21) Application number: 03013702.0
(22) Date of filing: 17.06.2003
(51) Int. Cl.: C30B 15/10

(54) **Doped silica glass crucible for making a silicon ingot**
Tiegel aus dotiertem Silicaglas zum Herstellen von Siliziumstäben
Creuset en verre de silice dopé pour la fabrication des lingots de silicium

(30) Priority: 18.06.2002 US 174875
(43) Date of publication of application: 02.01.2004
(73) Proprietor: Heraeus Quarzglas GmbH & Co. KG, 63450 Hanau (DE); Heraeus Shin-Etsu America, Inc., Camas, Washington 98607 (US)
(72) Inventor: Kemmochi, Katsuhiko, Ph.D., Vancouver, Washington 98607 (US); Mosier, Robert O., Vancouver, Washington 98684 (US); Spencer, Paul G., Stevenson, Washington 98648 (US)
(74) Representative: Staudt, Armin Walter

(56) References cited:
- EP-A- 1 319 736
- WO-A-02/40732
- WO-A-02/070414

## Description

### BACKGROUND OF THE INVENTION

The present invention is related to the field of silica crucibles, and more specifically to a silica crucible having a multi-layer wall in which one or more of the wall layers are doped with a crystallization agent.

A Czochralski (CZ) process is known in the art for producing single crystalline silicon ingots, from which silicon wafers are made for use in the semiconductor industry. In a CZ process, polycrystalline silicon is charged in a crucible typically housed within a susceptor. A single silicon crystal is pulled from the molten silicon.

Currently, the semiconductor industry is trending toward larger-diameter wafers, e.g., 300mm in diameter. To grow silicon ingots of this diameter, the CZ process operating time must be increased, sometimes to more than one hundred hours. As well, decreasing the crystal pulling rate, while minimizing the frequency of structural defects in the silicon crystal, in turn prolongs the CZ run time and further emphasizes the need to improve the useful life of the crucible.

Further, some silicon ingot manufacturers perform multiple silicon crystal "pulls" during a single CZ-process. In such uses, a portion of the crucible side wall is alternately covered by the melt, exposed to atmosphere as the melt level drops, then covered again as the next silicon charge is melted to begin another ingot pull. The inner surface of a crucible so used is subjected to high stress for a longer time period, making more important the inner surface integrity.

At operating temperatures, the innermost portion of a conventional silica crucible reacts with the silicon melt. The inner surface of the crucible typically undergoes a change in morphology and roughens during operation in a CZ run. As well, the high heat of a CZ process softens the walls of the crucible and increases the risk of crucible structural deformation.

Roughening on the crucible inner surface can cause crystal flaws in the ingot being pulled. When a major portion of the crucible inner surface roughens, crystalline structure is disrupted at the crystal-melt interface and silicon crystal pulling must be ceased. Roughening therefore renders the crucible unfit for continued use in silicon ingot manufacture.

Devitrification (i.e., crystallization) occurs in a shallow layer on the innermost portion of the crucible. The silica glass of a conventional crucible experiences a volume change as it crystallizes, creating stress at the vitreous phase-crystalline phase interfaces. Such stress is relieved by micro-scale deformation in the glassy phase of the crucible, deteriorating the smoothness of the inner surface.

Crucible devitrification typically occurs as circular patterns ("rosettes") that develop on the innermost portion of the crucible. The rosettes have been determined to be surrounded by cristobalite. The center of the rosette has a rough surface that is either not covered by cristobalite or covered by a very thin cristobalite layer.

During a CZ-process, rosettes form on the crucible inner surface, and the central surface regions of the rosettes roughen. The rosettes grow and merge, increasing the rough surface area of the crucible inner surface.

Additionally, the crucible inner layer can partially dissolve into the silicon melt during the CZ process. Silicon and oxygen, the main components of a silica crucible, do not cause flaws in the growing silicon ingot. However, impurities in the inner layer can be transferred to the silicon melt during this process and be incorporated into the silicon crystal.

Prior art attempts to control devitrification of a crucible inner surface have included coatings containing crystallization promoters, such as U.S. Patent No. 5, 976, 247. In that reference, a devitrification promoting solution is applied to the surface of a conventional, commercially available crucible. Upon heating to 600°C or greater, the inner surface is said to crystallize to some degree.

However, this surface coating technique has several drawbacks. It addresses only promotion of silica crystallization. Retardation of crystallization, and preservation of the glass of the crucible inner surface, cannot be obtained in the coated crucible. The coating technique also lacks control over the depth and rate of crystallization of the crucible. A coated crucible also must be specially handled, as inadvertent contact can result in removal of the crystallization promoter coating from the inner surface.

DE 102 31 865 A1 discloses a crucible adapted for use in formation of a silicon crystal, comprising: a crucible wall having an outer layer and an inner layer both containing aluminum.

WO 02/40732 A1 discloses a quartz crucible having a thermodynamically stable protective cooling layer. This coating is made of, for example litomoxyde and has preferentially a thickness of 0,025 to 0,25mm.

### BRIEF DESCRIPTION OF THE DRAWINGS

- **Fig. 1**: is a cross-sectional view of one embodiment of a silica glass crucible constructed according to the present disclosure.
- **Fig. 2**: is an enlarged, partial cross-sectional view of the wall of the silica glass crucible shown in Fig. 1.
- **Fig. 3**: is an enlarged, partial cross-sectional view of the wall of a first alternative embodiment of a silica glass crucible constructed according to the present disclosure.
- **Fig. 4**: is an enlarged, partial cross-sectional view of the wall of a second alternative embodiment of a silica glass crucible constructed according to the present disclosure.
- **Figs. 5-9**: are diagrams showing methods for making silica glass crucibles as described herein.
- **Figs. 10-12**: are partial plan views of an inner surface of a silica glass crucible of the prior art, showing rosettes occurring during a CZ-process:
- **Figs. 13-14**: are partial, enlarged top and cross-sectional views, respectively, of the prior art crucible wall shown in Fig. 10.
- **Figs. 15-16**: are partial, enlarged top and cross-sectional views, respectively, of an inner surface of a silica glass crucible according to the "CORONA" embodiment of the present invention.
- **Figs. 17-19**: are partial, enlarged top views of the inner surface of a "SMOOTH" embodiment crucible.
- **Figs. 20-21**: are partial, enlarged top and cross-sectional views, respectively, of the crucible wall and silica crystallization rosette depicted in Fig. 17.

### DETAILED DESCRIPTION OF THE PREFERRED EMBODIMENT(S)

Silica crucibles disclosed herein are adapted for use in formation of silicon crystals. The crucibles include a wall having an inner layer formed on an inner aspect of the crucible wall. Distributed within the inner layer is a crystallization agent that contains titanium.

The inner layers of crucibles disclosed herein are adapted to, when heated, crystallize according to any of three operating modes that retain a smooth inner surface and reinforce the structural rigidity of the crucible walls. The inner surface in the sense of the present application is the surface being in contact with the silicon melt.

Crucibles generally are made by forming a bulk grain layer on an interior surface of a rotating crucible mold, generating a high-temperature atmosphere in the crucible cavity, and introducing inner grain and crystallization agent into the high-temperature atmosphere, fusing the inner grain to form a doped inner layer.

The following sections describe in more detail the structure, methods for manufacture, and operating modes of the present crucibles.

### Structure of Doped-Layer Crucibles

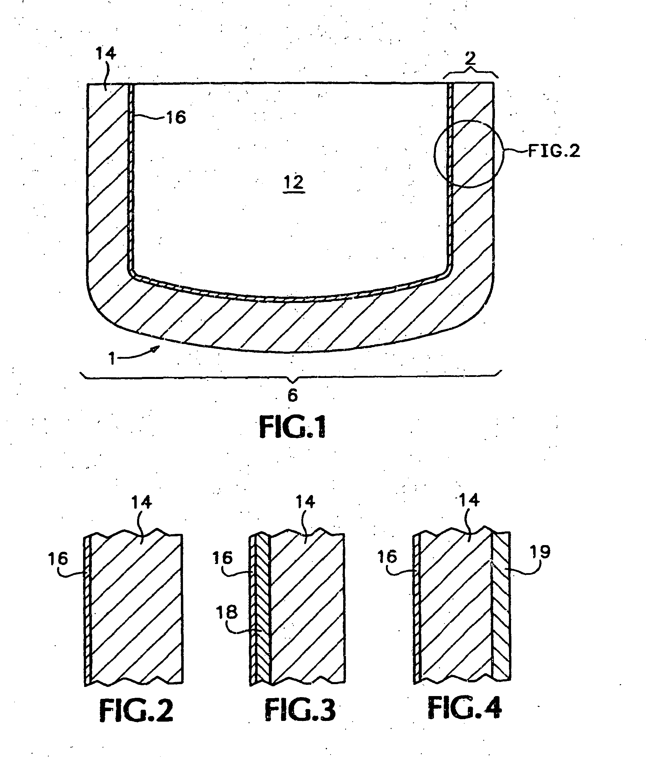

One embodiment of the crucible is shown in Figs. 1-2. A silica glass crucible 1 has a wall 2 defining an interior cavity 12. The wall 2 comprises side wall portion 4 and bottom wall portion 6.

The side wall portion 4 of this embodiment comprises bulk layer 14 of pure silica and inner layer 16 formed as the inner structure of side wall portion 4 and bottom wall portion 6. Bulk layer 14 generally is a translucent glass layer substantially comprised of silica.

Inner layer 16 consists essentially of fused doped silica and has a thickness in the range of 0.2 mm-1.0 mm. The inner layer preferably is free of bubbles, as bubbles entrapped within the inner layer may generate fracture-induced particles as the layer crystallizes. Such particles can dissociate or break away from the inner surface as the bubble expands and as the inner surface erodes or dissolves into the silicon melt. These particles can cause loss of the single-crystal structure in the silicon ingot.

Crystallization agent is distributed within fused silica inner layer 16. The crystallization agent is titanium.

Crystallization agent can be in a variety of chemical forms, such as elemental (e.g. Al) or an organic or inorganic compound such as an oxide, hydroxide, peroxide, carbonate, silicate, oxalate, formate, acetate, propionate, salicylate, stearate, tartrate, fluoride, or chloride. Preferably, crystallization agent is an oxide, hydroxide, carbonate or silicate.

Distribution within inner layer 16 of crystallization agent acts to promote crystallization of inner layer 16. The operational modes of the present crucibles are discussed more fully below.

In other embodiments, inner layer 16 can be formed on transition layer 18, the latter constructed of synthetic silica glass or pure silica glass (Fig. 3). Side wall portion 4 of this embodiment comprises bulk layer 14, transition layer 18 and inner layer 16. As in the embodiment of Figs. 1-2, bulk layer 14 typically is translucent silica glass and inner layer 16 likewise is doped as described.

Transition layer 18 can be non-doped silica glass, made from natural or synthetic silica grain. Alternatively, however, various materials can be employed in transition layer 18. For example, transition layer 18 also can be a doped layer. Crystallization agent therein can be the same or different than that used in inner layer 16.

In the alternative embodiment of the crucible shown in Fig. 4, outer layer 19 also is formed on the outer aspect of side wall portion 4. In one embodiment, outer layer 19 is approximately 0.5-2.5mm in thickness and can be doped with aluminum, barium, strontium or titanium. As well, a mixture of these agents can be effectively employed. Crystallization agent in outer layer 19 is generally in the range of about 50-500 ppm (here and in the following the term "ppm" means "wt-ppm")

In the crucible as represented in Fig. 4, side wall portion 4 typically has a thickness of approximately 10.0mm, of which bulk layer 14 comprises 6.5-9.4mm, inner layer 16 comprises 0.2-1.0mm, and outer layer 19 comprises the remaining 0.5-2.5mm.

Bottom wall portion 6 can be constructed so as to have a similar structure to side wall portion 4 of Figs. 2-4, but is preferably formed without outer layer 19.

It should be apparent that a crucible can be constructed having inner layer 16, transition layer 18, bulk layer 14, and outer layer 19.

### Methods for Manufacturing Doped-Layer Crucibles

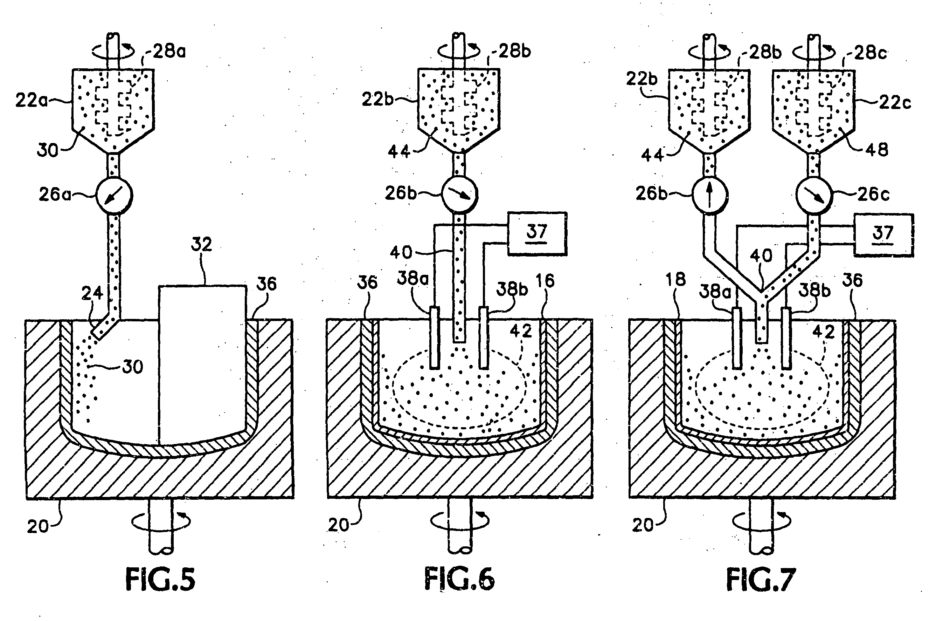

A method is disclosed herein for making a doped inner layer adapted to devitrify during a CZ run. The method shown in Figs. 5-6 is for making the crucible embodiment shown in Figs. 1-2.

A general method for making fused quartz glass crucibles is taught in U.S. Patent 5,174,801 (to Matsumura et al.). The method generally includes forming a crucible body from silica powder in a rotating mold (Fig. 5), heating the crucible body at the interior cavity thereof to at least partially melt the body and provide a crucible basic structure.

A high-temperature atmosphere is formed in the interior cavity of the crucible structure, and inner silica grain is supplied into the high-temperature atmosphere (Fig. 6). The inner silica grain at least partially melts and deposits on the inner wall surface of the crucible basic structure, thereby forming a transparent synthetic silica glass inner layer of a predetermined thickness.

The present method for manufacturing a crucible suitable for use in formation of a silicon crystal adapts the above method to form a crucible having inner layer 16 doped with crystallization agent.

To make the crucible embodiment shown in Figs. 1-2, bulk grain layer 36 is first formed by flowing bulk silica grain 30 from bulk silica grain hopper 22a through flow regulating valve 26a and feed tube 24 into rotating mold 20 (Fig. 5).

Bulk silica grain 30 is preferably pure quartz grain. Hopper stirring blade 28a can be used to stir bulk silica grain 30 in hopper 22a and facilitate flow therefrom. Spatula, 32 is shaped to conform to the inner surface of the mold, is generally used to shape introduced bulk silica grain. In this manner, bulk grain layer 36 can be formed to a selected thickness.

The method proceeds with fusion of formed bulk silica layer 36 (Fig. 6). An electrode assembly, including power source 37 and electrodes 38a,38b, is positioned partially within the interior cavity of mold 20. An electric arc is produced between electrodes 38a,38b, e.g., by supplying 250-350V and approximately 1800A direct current. A high-temperature atmosphere 42 is thereby generated within the mold interior. This high-temperature atmosphere 42 is sufficient to fuse the formed bulk grain layer 36 in the mold.

Fusion proceeds through formed bulk grain layer 36 from proximal to distal relative to electrodes 38a,38b. The progressive fusion through the silica grain layer according to this technique is known to those skilled in the art, for example, as disclosed in U.S. Patent Nos. 4,935,046 and 4,956,208 both to Uchikawa et al.

Contemporaneous with fusion of the surface of formed bulk grain layer 36, inner silica grain 44 is flowed from inner silica grain hopper 22b through feed tube 40 and into the high-temperature atmosphere 42. Inner grain flow regulating valve 26b can be utilized to control the flow rate of inner silica grain 44. Hopper stirring blade 28b can be used as described above.

Inner silica grain 44 consists essentially of pure silica grain, such as natural silica grain washed to remove contaminants, doped with crystallization agent. Alternatively, synthetic silica grain doped with crystallization agent can be used.

The high-temperature atmosphere 42 produced by the electrode arc creates a very strong plasma field, at least partially melting inner silica grain 44. The at least partially molten inner silica grain 44 is propelled outward and fuses to the sides and bottom of formed bulk grain layer 36/fused bulk layer 14 to form inner layer 16.

In Fig. 6, the bulk layer is numbered as 36 representing bulk grain layer for convenience. At this stage in the method, of course, this layer is actually a changing combination of fused bulk layer 14 and unfused bulk grain layer 36.

Inner layer 16 is substantially continuously formed during the time that inner silica grain 44 is flowed into the high-temperature atmosphere 42 and fused to bulk layer 14. Inner layer 16 thus formed is essentially transparent and bubble-free. The thickness of inner layer 16 can be controlled by the introduction rate of inner silica grain and by the period of inner grain flow during fusion.

A method for making a crucible having both inner layer 16 and transition layer 18 comprises the steps shown in Figs. 5 and 7-8.

After formation of bulk grain layer 36 (Fig. 5), the electrode assembly is positioned within the crucible interior cavity. Transition grain 48 is supplied from transition grain hopper 22c through flow controlling valve 26c (Fig. 7). Hopper stirring blade 28c can be employed similarly to stirring blades 28a,28b.

Transition silica grain 48 is at least partially melted in the high-temperature atmosphere 42 and fuses on formed bulk grain layer 36/fused bulk layer 14 to form transition layer 18. The thickness of transition layer 18 also can be controlled by regulating the rate and time of transition silica grain 48 flow.

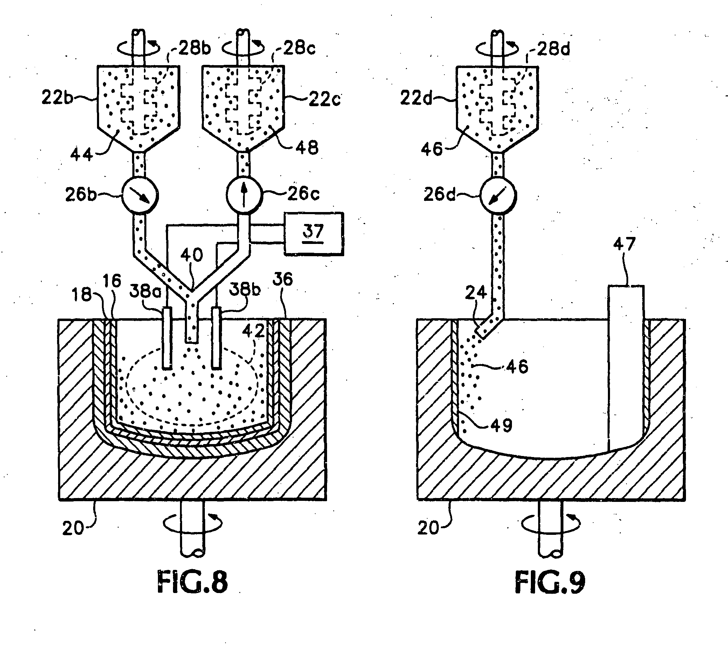

After formation of transition layer 18, inner silica grain 44 is then introduced into the high-temperature atmosphere 42 (Fig. 8). As before, inner silica grain 44 is at least partially melted and deposited as inner layer 16 on transition layer 18.

Crystallization agent-doped inner layer can be formed on a variety of transparent transition layer compositions. For example, transition layer 18 can be a pure silica layer or a doped layer. The crystallization agent-doped inner layer can be deposited on a transparent layer made of synthetic silica grain or pure silica grain (i.e., purified natural quartz).

A similar method is used to construct a crucible having outer layer 19 (Fig. 4). Outer grain layer 49 is first formed in rotating mold 20 (Fig. 9). Outer grain hopper 22d communicates via feed tube 24 with the interior of mold 20. Feed tube 24 can employ valve 26d to regulate the flow of outer silica grain 46 from hopper 22d to the interior of the mold. The thickness of outer grain layer 49 can be controlled using spatula 47. Manufacture of the crucible then proceeds as described above.

Outer layer 19 also can be doped with crystallization agent. Doped outer layer 19 can be constructed to readily crystallize and thereby improve dimensional stability at high temperatures, without affecting or contaminating the silicon melt.

Aluminum typically is less costly than other compounds, and disposal of unfused aluminum-doped outer silica grain is more environmentally convenient. A mixture of pure silica grain and aluminum-doped outer silica grain 46 therefore is preferred, although other dopants or mixed grains can also be employed.

### Methods of Crystallization Agent Introduction

In the embodiment of the present method thus described, inner silica grain 44 is doped with the crystallization agent. As has been mentioned, the crystallization agent contains titanium and can contain aluminum, barium or strontium, in either elemental form or as a compound. Oxides and nitrides are two preferred forms of the crystallization agent in compound form.

A mixture of doped silica grain and undoped silica grain can also be employed, so long as the selected final agent concentration is achieved. When synthetic silica grain is used as the undoped silica grain in the mixture, it is observed that the crystallization promoting strength of the crystallization agent is enhanced. Glass formed of synthetic silica is softer than natural silica glass (i.e., fused quartz glass). The softer matrix of synthetic silica glass is more favorable to crystallization, likely because of an increased tolerance (i.e., decreased structural resistance) to the volume changes associated with the phase transition from amorphous silica glass to crystalline silica such as cristobalite. As a result, similar level of transformation can be obtained at a lower doping level when synthetic silica grain is incorporated in fused inner layer 16 or outer layer 19.

By preparing a silica sol containing crystallization agent, uniformly doped silica gel can be obtained. This gel can be another example of the doped grain. The gel preferably is calcined to convert it to pure silicon dioxide.

Alternatively to doping of silica grain, crystallization agent can be borne on silica grain by coating silica grain or by formation of an agent-bearing silica gel. The coated grain can formed by coating pure silica grain with an organic material, e.g., an alcoholate.

In another alternative introduction scheme, crystallization agent can be mixed and introduced contemporaneously with undoped silica grain, such as either natural or synthetic silica grain. For example, barium carbonate (BaCO₃) can be added to inner silica grain 44 in hopper 22b. Mixing blade 28b can be used to ensure uniform blending of barium carbonate and inner silica grain. The mixture of inner silica grain and barium carbonate then can be flowed into the high-temperature atmosphere 42, as described above.

During fusion of inner silica grain 44, crystallization agent can be supplied into the high-temperature atmosphere 24 as inorganic powder, complex oxide (e.g., TiBaO₃) or as a complex or mixture of a plurality of such compounds.

Organic compounds, which convert to one of the above-mentioned species at the high temperatures of crucible fusion, can be used in a similar manner.

In an alternative embodiment of the method, crystallization agent can be separately introduced from a dedicated hopper into the high-temperature atmosphere 24 contemporaneous with introduction of inner silica grain 44. Valves controlling flow of contents from inner grain hopper and agent hopper, similar to those previously described herein, can both be opened so as to flow concurrently.

In yet another example, crystallization agent can be in liquid form. Liquid solution can be introduced into inner silica grain 44 prior to or contemporaneous with introduction of inner silica grain 44 into the high-temperature atmosphere 24.

Liquid solution alternatively can be introduced directly into the high-temperature atmosphere 24 contemporaneous with flow of inner silica grain 44, for example by an injector generally positioned adjacent the end of flow tube 40 proximate the high-temperature atmosphere 24. Liquid solution can be either aqueous or organic, so long as the chosen solvent does not present a potential source of ingot contamination.

Crystallization agent in liquid solution can also be applied to a formed grain layer prior to fusion. An organic compound, organic solution or aqueous solution of crystallization agent can be sprayed onto formed outer grain layer 49. A benefit of application of agent to a formed grain layer is control of localization of agent to a specific region of the layer. For example, crystallization agent can be applied to only the inner aspect of side wall portion 4 or bottom wall 6, to the entire (side and bottom) inner aspect of side wall portion4 and bottom wall portion 6, or only to that inner aspect of side wall portion 4 that is below the contemplated melt-line (melt-line is the line where molten silicon contacts the crucible interior wall after melt-down). Using the above method in which the crystallization agent is introduced concurrently with but separate from the inner silica grain, transition silica grain 48 can also be employed as inner silica grain 44. For example, transition silica grain 48 can be flowed into the high-temperature atmosphere 24 to form transition layer 18 as described above. Transition hopper flow is stopped, and then both transition silica grain 48 and barium compound are flowed simultaneously into the high-temperature atmosphere 24 to form inner layer 16.

### Operational Modes of Doped-Laver Crucibles

Selection of the doping element for use in inner layer 16 is dictated by the operational mode desired. Each of the agents possesses unique crystallization-promoting strengths and, in tandem with agent doping levels, can be used to control the rate and extent of silica crystallization of inner layer 16.

A discussion of the operational modes and the use of various agents to achieve these modes begins with a review of the rosette phenomenon observed on the inner surface of a crucible used in a CZ process. From an operational perspective, it is desirable to retain a smooth surface primarily on that portion of the inner layer whose surface contacts the melt when the crucible is used in silicon ingot formation. It should therefore be noted that, in the following discussion, the crucible "inner layer" and "inner surface" refer to this operationally more significant portion of the inner layer.

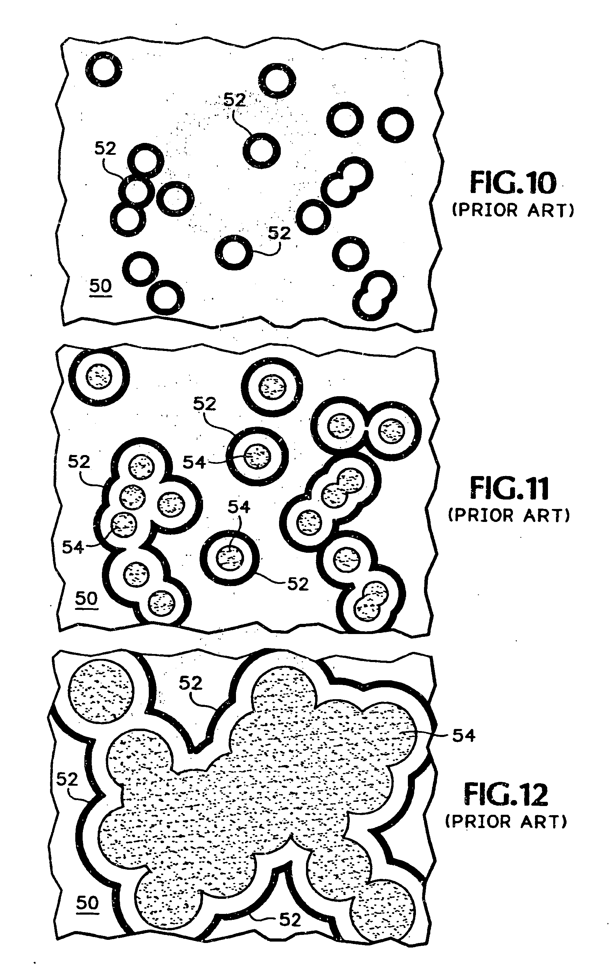

In more detail, the rosette phenomenon observed on the inner surface of a prior art crucible in shown in Figs. 10 - 14. Fig. 10 depicts an inner surface 50 of a crucible, on which have formed a plurality of rosettes where the crucible surface 50 contacts the silicon melt. A rosette generally has a ring 52; the ring and the region inside the ring are cristobalite 56.

During a CZ-process, the rosettes grow in area, spreading to cover an increasing percentage of the inner layer surface 50, as shown in Fig. 11. As the rosette grows, a rough texture 54 appears in the center. The rough surface area 54 within the boundaries of the rosettes also expands across the crucible inner surface. Fig. 12 shows the state of an exemplary crucible inner surface 50 of the prior art later in the CZ-process. Rosettes merge and the rough surface area 54 is increased. As discussed above, inner surface roughening adversely impacts the crystalline structure of the growing silicon ingot.

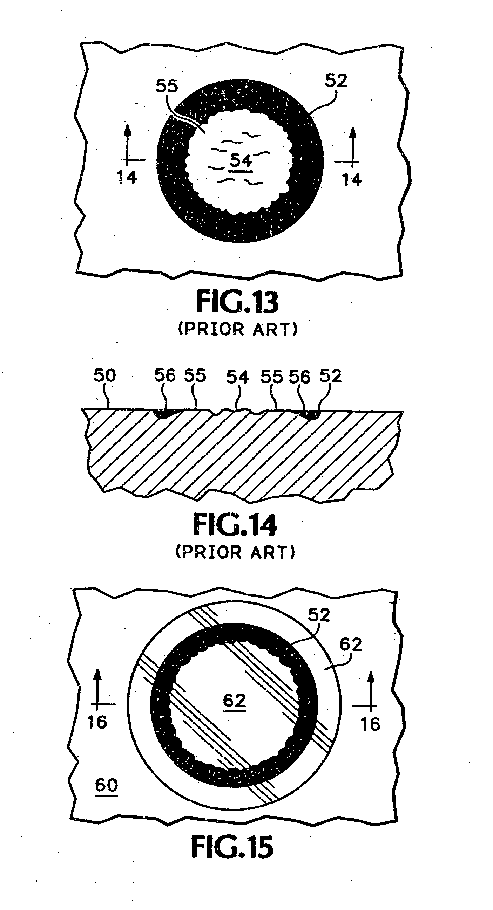

Enlarged top and cross-sectional views of a rosette of the prior art are shown in Figs. 13-14. The center of the rosette has a rough surface texture 54 surrounded by cristobalite (crystalline silica) 56, the latter of which is seen to extend into the crucible wall from inner surface 50. The cristobalite ring 52 is decorated with brown materials and normally is observed as a brown ring on the inner surface of a used crucible. In some rosettes of the prior art, a small smooth surface boundary 55 exists between the rough area 54 and the inner edge of the ring 52.

Regarding rosettes and concomitant surface roughening, the present invention employs a combination of factors, discussed below, to provide a crucible inner layer adapted to operate according to one of three crystallization modes, designated herein as FULL, SMOOTH, and CORONA. In each of these modes, the crucible is suitable for use in an extended CZ-process without inner surface roughening or significant dissolution.

"FULL" Mode. In this mode, the inner surface of the crucible is adapted to be crystallized when heated and before contacted with the silicon melt. In this mode, generation of rosettes is suppressed, i.e., rosettes are not observed during or after a CZ run.

The inner surface of a FULL mode crucible therefore is covered with β-cristobalite after heating and before melt-down of the silicon. As a result, rosettes are not formed by a reaction between the silicon melt and crystalline silica. Lack of rosette generation means roughening of the inner surface is suppressed and the crucible inner surface remains smooth.

"CORONA" Mode. The second mode of maintaining a smooth crucible inner surface is to stifle expansion of rosettes (Figs. 15- 16). Ring 52 of a rosette is cristobalite, which may act as a nucleation site to grow crystalline silica 56 in the silica glass of inner layer 16. However, there exists a disparity in phase transition propagation rates between the central region of the rosette and the corona around the ring 52.

A cristobalite corona or halo grows faster than growth of cristobalite ring 52, such that ring 52 is surrounded by crystalline silica 56. When ring 52 is so bounded by crystalline silica 56, it is observed that the growth rate of the rosette is decreased by at least 50%.

This crystallization rate disparity is exploited, resulting in rings surrounded by corona-like crystalline phase "coronas" and suppression ring growth. Consequently, phase transition of inner layer 16 from silica glass to β-cristobalite proceeds slowly (i.e., rapid crystallization does not occur as it does in "FULL" mode) and a large amount of the original glass is retained for a prolonged time.

The combination of a large smooth surface 60 and slow-growing smooth cristobalite surface 56 combine to maintain a substantially vitreous inner layer for a longer period than in a conventional crucible. The inner surface of a "CORONA" crucible does not degrade as rapidly as in the prior art.

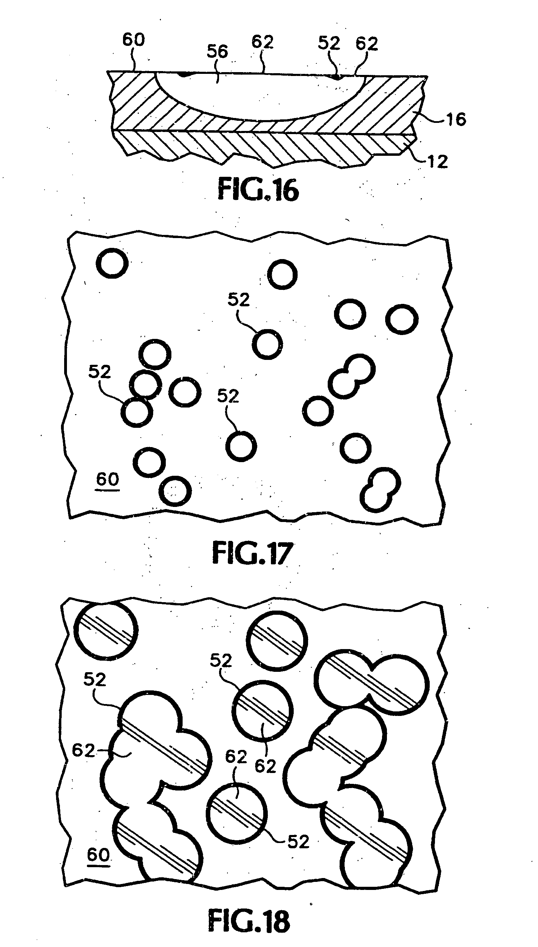

"SMOOTH" Mode. A third mode of maintaining crucible usefulness is to prevent generation of rough area 54. Rosettes are observed to form on the inner surface of a "SMOOTH" mode crucible (Fig. 17) similarly to those formed on walls of a prior art crucible (compare with Fig. 10). "SMOOTH" crucible rosettes continue to grow and merge (Figs. 18-19), as occurs on prior art crucible inner surfaces 50.

Nevertheless, silica crystallization within inner layer 16 occurs more slowly than in either "FULL" or "CORONA" mode crucibles. Although inner layer 16 does not undergo a phase transition as rapidly, the vitreous silica layer nevertheless is not observed to undergo conventional, undesirable devitrification (i.e., roughening and potential degradation). The "SMOOTH" crucible inner surface 60 retains a smooth texture 62.

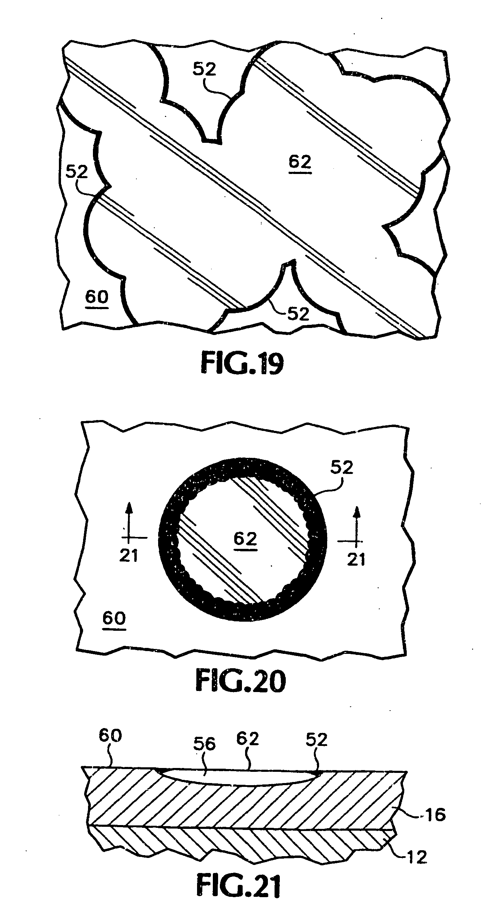

Figs. 20 - 21 show a plan view and an enlarged cross-sectional view of a rosette growing on inner surface 62 of a "SMOOTH" crucible. The rosette comprises ring 52 at the outer boundary of the rosette, within which is found cristobalite 56. The cristobalite 56 extends into inner layer 16.

In contrast to the crucible inner surface 50 of the prior art (Figs. 13-14), the "SMOOTH" crucible retains a smooth surface within ring 52 and rosette. Even after the "SMOOTH" crucible surface is covered by merged rings, it is observed that roughening is substantially prevented as compared to conventional crucibles.

### Selection and Control of Operational Modes

The present invention permits selection among these three modes to suit the particular application desired. A crucible can be constructed to operate in one of the above three operational modes by a variety of factors, including crystallization agent identity and level, manner in which the agent is introduced into the high-temperature atmosphere, and post-fusion handling of the crucible.

### Crystallization agent and control of cristobalite formation.

The rate of cristobalite growth is a primary means by which mode selection is accomplished. Crystallization will occur most rapidly in "FULL" mode, then "CORONA" mode, and lastly "SMOOTH" mode.

In terms of strength in silica crystallization promotion, group 2A elements are the strongest, followed by group 3B elements, and then group 4A elements. Thus, of the above-mentioned crystallization agents at equal doping levels, however, the strongest is strontium (group 3B), followed by barium (group 2A), then aluminum (group 3B), and then titanium (group 4A).

A combination of two or more of these elements in a mixture or as a multi-layer crucible can also be employed. Alkaline elements (i.e., group 1A members such as Li, Na, K) can be used but are not preferred because they tend to diffuse and will not be confined within the doped layer.

Silica crystallization also is affected by crystallization agent level. Generally, higher doping levels enhance the cristobalite growth rate. Using aluminum as an example, cristobalite formation proceeds more rapidly in a layer doped at 250 ppm than in a layer doped at 25 ppm.

The cristobalite growth rate is increased using a thinner inner layer. A crucible constructed with a 0.2 mm thick inner layer 16 demonstrated faster phase transition than did a crucible possessing a 1.2 mm thick layer.

Faster cristobalite growth generally results from non-homogeneous doping, and especially with non-homogeneous doping using a mixture comprising synthetic silica grain (amorphous) rather than crystalline silica grain (quartz).

As stated, the above factors can be controlled to produce thereby a crucible adapted to operate in either of "FULL", "CORONA" or "SMOOTH" mode. For simplicity, the following examples address inner layer 16, although the same principles apply to outer layer 19.

Example A: "FULL" mode crucible. An exemplary crucible operative in "FULL" mode uses a relatively strong crystallization-promoting agent or a relatively high doping level.

Inner layer 16 of a "FULL" mode crucible typically has a thickness in the range of 0.2-1.2 mm. The precise thickness of inner layer 16 must be determined in concert with the type of silica grain, the specific crystallization agent and its method of agent introduction.

Alternative "FULL" mode crucibles can be manufactured with fusion of inner silica grain 44 that has been coated-rather than doped-with crystallization agent. Use of coated inner silica grain 44 results in non-homogeneous distribution of crystallization agent within inner layer 16. Similarly, substantially contemporaneous flow of inner silica grain 44 and crystallization agent also non-homogeneously distributes agent within the fused layer 16.

Example B: "CORONA" mode crucible. A crucible adapted to operate in "CORONA" mode typically has a crystallization agent of moderate crystallization-promoting strength within its inner layer at a lower to moderate doping level. The doped layer can have a thickness in the range of about 0.5-1.2 mm.

Because it is undesirable to confer rapid crystallizing ability on the entire inner layer in this mode, strong crystallization promoters such as barium and strontium can be used but are not preferred for use in this mode. Similarly, natural silica grain is preferred over synthetic silica grain for use as inner silica grain 44. It is readily apparent, however, that the addition of synthetic silica grain to doped inner grain 44 (or use of doped synthetic inner silica grain) can permit use of a weaker crystallization agent.

As well, doped silica grain is preferred over coated silica grain or contemporaneous introduction, so that crystallization promoter is substantially evenly distributed within inner layer16. This preference remains despite formation of a crystallization agent gradient distribution with inner layer 16, as described in an alternative method above.

Example C: "SMOOTH" mode crucible. A crucible operating this mode retains a smooth surface by slow progression of silica crystallization in the inner aspect of the side wall portion 4 and bottom wall portion 6. Inner layer 16 of a "SMOOTH" crucible preferably has a crystallization agent with weak to moderate crystallization promoter strength. Crystallization agent is distributed within inner layer 16, for example, 100 ppm titanium in a doped layer made of fused natural inner silica grain.

Depending on the particular crystallization agent chosen and the use of synthetic inner silica grain 44, thinner inner layers can be formed that operate efficaciously.

Crucible design should preferably be tuned to the conditions of the contemplated CZ-process, and specifically to the heating schedule of the process.

The methods disclosed above distribute a crystallization agent within a crucible inner layer, rather than coating the interior surface of a crucible with a devitrification promoter. Layer doping, has several merits over conventional coating methods.

The present method enables the crystallization agent concentration in inner layer 16 or outer layer 19 to be finely controlled. The amount of crystallization agent contained in the agent-doped grain can be precisely determined in advance by analysis. Crystallization agent level in inner layer 16 can thereby be finely controlled by, for example, mixing doped silica grain and pure silica grain in the hopper.

The thickness of inner layer 16 also can be manipulated by changing inner silica grain flow rate or flow time. No loss of crystallization promoter has been observed, e.g., loss due to sublimation, when the manufacturing methods were carried out. Substantially all of the introduced agent was found to be fixed within inner layer 16.

Moreover, doping of a three-dimensional layer permits a smaller total amount of crystallization agent to be used compared to the prior art. Calculations were performed, based on the amount of crystallization agent introduced into the high-temperature atmosphere and the inner surface area of the crucible.

Because the crystallization agent is distributed and fused within the silica glass, crucibles also can be machined to dimensions, cleaned or etched, and handled with the same procedures as for normal pure silica crucibles. No additional post-manufacture processing or special handling of crucibles is required.

For example, unfused grain remaining on the outside of a conventional crucible can be cleaned by sand-blasting, followed by rinsing with water. After cutting the crucible to specified dimensions, it can be cleaned by etching with dilute hydrofluoric acid and rinsing with pure water. The crucible then can be dried in a clean air bath, then bagged and boxed for shipment.

A crucible constructed according to the present disclosure can be cleaned or otherwise handled without removal of crystallization agent from inner layer 16 or outer layer 19.

## Claims

1. A silica crucible adapted for use in formation of a silicon crystal, comprising:
a crucible wall including a bottom wall and a side wall; and
an inner silica layer formed on an inner portion of said crucible wall, said inner layer consists of fused doped silica having a thickness in the range of 0.2 - 1.2 mm and partially having distributed therein a crystallization agent containing titanium and adapted to, when heated, substantially crystallize.

2. The crucible of claim 1, wherein said inner layer having partially having distributed therein a crystallization agent containing one element or a plurality of elements selected from the group consisting of barium, aluminum and strontium.

3. The crucible of claim 1, wherein said crystallization agent is titanium distributed in the inner layer at a level in the range of 50 - 200 ppm.

4. The crucible of claim 3, wherein titanium is distributed in the inner layer at a level in the range of 80 - 160 ppm.

5. A method for manufacturing a silica crucible adapted for use in formation of a silicon crystal, comprising:
a) forming a bulk grain layer on an interior surface of a rotating crucible mold, said bulk grain layer having a bottom portion, a side portion, a bulk grain layer interior surface and defining a crucible cavity; and
b) forming an inner layer which on said cavity by introducing inner silica grain, and
c) introducing a crystallization agent into said cavity, said crystallization agent contain titanium,
wherein a high-temperature atmosphere is generated between steps a) and b) in said crucible cavity thereby introducing said crystallization agent and said inner silica grain into the high-temperature atmosphere resulting in a inner layer which consists of fused doped silica having a thickness in the range of 0.2 - 1.2 mm.

6. The method of claim 5, wherein said crystallization agent contains an element selected from the group consisting of barium, aluminum and strontium.

7. The method of claim 5, wherein said crystallization agent comprises a compound operative to be converted by the high-temperature atmosphere into an oxide, nitride, chloride or halide.

8. The method of claim 5, wherein introducing inner grain and crystallization agent comprises contemporaneously introducing pure inner grain and introducing crystallization agent.

9. The method of claim 5 or claim 6, wherein by adding said inner grain an inner grain layer is formed on the bulk grain layer interior surface, and wherein a high-temperature atmosphere is generated between steps a) and b) in said crucible cavity, thereby at least partially melting the inner grain layer, and wherein said crystallization agent is introduced into said high-temperature atmosphere.

10. The method of claim 5 or claim 9, wherein introducing inner grain and crystallization agent comprises introducing doped inner grain, said doped inner grain being doped with the crystallization agent.

11. The method of claim 10, wherein doped inner grain comprises doped natural silica grain or doped synthetic silica grain.

12. The method of claim 10, further comprising introducing pure inner grain contemporaneous with the doped inner grain.

13. The method of claim 12, wherein pure inner grain comprises pure natural inner grain or pure synthetic inner grain.

14. The method of claim 5 or claim 9, wherein introducing inner grain and crystallization agent comprises introducing crystallization agent-coated inner grain.

15. The method of claim 14, wherein said coated inner grain comprises coated natural silica grain or coated synthetic silica grain.

16. The method of claim 5, wherein crystallization agent-coated inner grain comprises coated inner grain and pure inner grain.

17. The method of claim 16, wherein pure inner grain comprises pure natural inner grain or pure synthetic inner grain.

18. The method of claim 9, wherein crystallization agent comprises an oxide, hydroxide, peroxide, carbonate, silicate, oxalate, formate, acetate, propionate, salicylate, stearate, tartrate, fluoride, or chloride.

19. The method of claim 5 or claim 9, wherein introducing crystallization agent comprises introducing solid crystallization agent.

20. The method of claim 5 or claim 9, wherein introducing solid crystallization agent comprises introducing crystallization agent-doped silica gel.

21. The method of claim 5 or claim 9, wherein introducing crystallization agent comprises spraying liquid-phase crystallization agent.

## Patentansprüche

1. Quarzglastiegel geeignet zur Verwendung bei der Herstellung eines Siliziumkristalls, umfassend:
eine Tiegelwand mit einer Bodenwand und einer Seitenwand und
eine SiO₂-Innenschicht, die auf einem Innenbereich der Tiegelwand ausgebildet ist, wobei die Innenschicht aus geschmolzenem dotiertem Quarzglas mit einer Dicke im Bereich von 0,2 bis 1,2 mm besteht und darin teilweise ein Kristallisationsmittel verteilt ist, das Titan enthält und beim Erhitzen im Wesentlichen kristallisieren kann.

2. Tiegel nach Anspruch 1, wobei die Innenschicht darin teilweise verteilt ein Kristallisationsmittel aufweist, das ein oder mehrere Elemente aus der Gruppe aus Barium, Aluminium und Strontium enthält.

3. Tiegel nach Anspruch 1, wobei das Kristallisationsmittel Titan ist, das in der Innenschicht mit einem Gehalt im Bereich von 50 - 200 ppm verteilt ist.

4. Tiegel nach Anspruch 3, wobei Titan in der Innenschicht mit einem Gehalt im Bereich von 80 - 160 ppm verteilt ist.

5. Verfahren zum Herstellen eines Quarzglastiegels geeignet zur Verwendung bei der Bildung eines Siliziumkristalls, umfassend:
a) Bilden einer Schüttkörnungsschicht auf einer Innenfläche einer sich drehenden Tiegelform, wobei die Schüttkörnungsschicht einen Bodenbereich, einen Seitenbereich, eine Schüttkörnungsschicht-Innenseite aufweist und einen Tiegel-Hohlraum definiert, und
b) Bilden einer Innenschicht in dem Hohlraum durch Einführen einer SiO₂-Innenkörnung, und
c) Einführen eines Kristallisationsmittels in den Hohlraum, wobei das Kristallisationsmittel Titan enthält,
wobei eine Hochtemperaturatmosphäre zwischen den Schritten a) und b) in dem Tiegel-Hohlraum geschaffen wird, wodurch das Kristallisationsmittel und die SiO₂-Innenkörnung in die Hochtemperaturatmosphäre eingeführt werden, was zu einer Innenschicht führt, die aus geschmolzenem dotiertem Quarzglas mit einer Dicke im Bereich von 0,2 - 1,2 mm besteht.

6. Verfahren nach Anspruch 5, wobei das Kristallisationsmittel ein Element aus der Gruppe aus Barium, Aluminium und Strontium enthält.

7. Verfahren nach Anspruch 5, wobei das Kristallisationsmittel eine Verbindung aufweist, die sich durch die Hochtemperaturatmosphäre in ein Oxid, Nitrid, Chlorid oder Halogenid umwandeln lässt.

8. Verfahren nach Anspruch 5, wobei das Einführen von Innenkörnung und Kristallisationsmittel das gleichzeitige Einführen einer reinen Innenkörnung sowie das Einführen von Kristallisationsmittel umfasst.

9. Verfahren nach Anspruch 5 oder Anspruch 6, wobei durch die Zugabe der Innenkörnung eine Innenkörnungsschicht auf der Innenfläche der Schüttkörnungsschicht gebildet wird und wobei eine Hochtemperaturatmosphäre zwischen den Schritten a) und b) in dem Tiegel-Hohlraum geschaffen wird, wodurch zumindest teilweise die Innenkörnungs-Schicht aufgeschmolzen wird und wobei das Kristallisationsmittel in die Hochtemperaturatmosphäre eingeführt wird.

10. Verfahren nach Anspruch 5 oder Anspruch 9, wobei das Einführen von Innenkörnung und Kristallisationsmittel das Einführen einer dotieren Innenkörnung umfasst, wobei die dotierte Innenkörnung mit dem Kristallisationsmittel dotiert ist.

11. Verfahren nach Anspruch 10, wobei die dotierte Innenkörnung dotierte natürliche Quarzkörnung oder dotierte synthetische Quarzglaskörnung aufweist.

12. Verfahren nach Anspruch 10, des Weiteren umfassend das Einführen von reiner Innenkörnung gleichzeitig mit der dotierten Innenkörnung.

13. Verfahren nach Anspruch 12, wobei eine reine Innenkörnung eine reine natürliche Innenkörnung oder eine reine synthetische Innenkörnung aufweist.

14. Verfahren nach Anspruch 5 oder Anspruch 9, wobei das Einführen von Innenkörnung und Kristallisationsmittel das Einführen einer mit Kristallisationsmittel beschichteten Innenkörnung umfasst.

15. Verfahren nach Anspruch 14, wobei die beschichtete Innenkörnung eine beschichtete Körnung aus natürlichem Quarz oder eine beschichtete Körnung aus synthetischem Quarzglas aufweist.

16. Verfahren nach Anspruch 5, wobei eine mit Kristallisationsmittel beschichtete Innenkörnung einen beschichtete Innenkörnung und eine reine Innenkörnung aufweist.

17. Verfahren nach Anspruch 16, wobei eine reine Innenkörnung eine reine natürliche Innenkörnung oder eine reine synthetische Innenkörnung aufweist.

18. Verfahren nach Anspruch 9, wobei das Kristallisationsmittel ein Oxid, Hydroxid, Peroxid, Karbonat, Silikat, Oxalat, Formiat, Azetat, Propionat, Salicylat, Stearat, Tartrat, Fluorid oder Chlorid aufweist.

19. Verfahren nach Anspruch 5 oder 9, wobei das Einführen von Kristallisationsmittel das Einführen eines festen Kristallisationsmittels umfasst.

20. Verfahren nach Anspruch 5 oder Anspruch 9, wobei das Einführen von festem Kristallisationsmittel das Einführen eines mit Kristallisationsmittel dotierten Silica-Gels umfasst.

21. Verfahren nach Anspruch 5 oder Anspruch 9, wobei das Einführen von Kristallisationsmittel das Aufsprühen eines Kristallisationsmittels in der Flüssigphase umfasst.

## Revendications

1. Creuset de silice approprié pour la formation d'un cristal de silicone comprenant :
une paroi de creuset incluant une paroi de fond et une paroi latérale
et une couche de silice interne formée sur une portion interne de ladite paroi de creuset, ladite couche interne étant constituée de silice dopée de fusion ayant une épaisseur comprise entre 0,2 et 1,2 mm et partiellement ayant un agent de cristallisation distribué contenant du titane et adapté lors du chauffage essentiellement à la cristallisation.

2. Creuset de la revendication 1, dans lequel ladite couche interne ayant un agent de cristallisation partiellement distribué contenant un élément ou une pluralité d'éléments sélectionnés parmi le groupe constitué de baryum, d'aluminium et strontium.

3. Creuset selon la revendication 1, dans lequel ledit agent de cristallisation est du titane distribué dans la couche interne à un niveau compris entre 50 et 200 ppm.

4. Creuset de la revendication 3, dans lequel le titane est distribué dans la couche interne à un niveau compris entre 80 et 160 ppm.

5. Procédé de fabrication d'un creuset de silice approprié pour l'utilisation dans la formation d'un cristal de silicium comprenant
a) la formation d'une couche de grain en vrac sur une surface intérieure d'un moule de creuset rotatif, ladite couche de grain en vrac ayant une portion de fond, une portion latérale, une surface intérieure de couche de grain en vrac et définissant une cavité de moule; et
b) formation d'une couche interne sur ladite cavité en introduisant un grain de silice interne et
c) introduction d'un agent de cristallisation dans ladite cavité, ledit agent de cristallisation contenant du titane,
dans lequel une atmosphère à haute température est générée entre les étapes a) et b) dans ladite cavité de creuset en introduisant ledit agent de cristallisation et ledit grain interne de silice dans l'atmosphère de température élevée résultant en une couche interne qui se compose de silice dopée en fusion ayant une épaisseur comprise entre 0,2 et 1,2 mm.

6. Procédé de la revendication 5, dans lequel ledit agent de cristallisation contient un élément sélectionné parmi le groupe constitué de baryum, aluminium et strontium.

7. Procédé de la revendication 5, dans lequel ledit agent de cristallisation comprend un composé opérationnel pour être converti dans une atmosphère à température élevée en oxyde, nitrure, chlorure ou halogénure.

8. Procédé de la revendication 5, dans lequel l'introduction de grain interne et d'agent de cristallisation comprend de manière contemporaine l'introduction de grain interne pur et l'introduction d'agent de cristallisation.

9. Procédé de la revendication 5 ou de la revendication 6, dans lequel en ajoutant ledit grain interne, une couche de grain interne est formée sur la surface intérieure de couche de grain en vrac, et dans lequel une atmosphère à température élevée est générée entre les étapes a) et b) dans ladite cavité de creuset, mettant partiellement en fusion au moins partiellement la couche de grain interne et dans lequel le dit agent de cristallisation grain en vrac est introduit dans ladite atmosphère à haute température.

10. Procédé de la revendication 5 ou de la revendication 9, dans lequel l'introduction de grain interne dopé et l'agent de cristallisation comprend l'introduction de grain interne dopé, ledit grain interne dopé étant dopé avec l'agent de cristallisation.

11. Procédé de la revendication 10, dans le grain interne dopé comprend du grain de silice naturel dopé ou du grain de silice synthétique dopé.

12. Procédé de la revendication 10, comprenant en outre l'introduction de grain interne pur en même temps que le grain interne dopé.

13. Procédé de la revendication 12, dans lequel le grain interne pur comprend un grain interne naturel pur ou un grain interne pur synthétique.

14. Procédé de la revendication 5 ou de la revendication 9, dans lequel l'introduction du grain interne et de l'agent de cristallisation comprend l'introduction de grain interne revêtu d'agent de cristallisation.

15. Procédé de la revendication 14, dans lequel ledit grain interne revêtu comprend le grain de silice naturel revêtu ou le grain de silice synthétique revêtu.

16. Procédé de la revendication 5, dans lequel le grain interne revêtu de l'agent de cristallisation comprend un grain interne revêtu et un grain interne pur.

17. Procédé la revendication 16, dans lequel le grain interne revêtu pur comprend un grain interne naturel pur ou un grain interne synthétique pur.

18. Procédé de la revendication 9, dans lequel l'agent de cristallisation comprend un oxyde, un hydroxyde, un peroxyde, un carbonate, un silicate, un oxalate, un formate, un acétate, un propionate, un salicylate, un stéarate, un tartrate, un fluorure ou un chlorure.

19. Procédé de la revendication 5 ou de la revendication 9, dans lequel l'introduction de l'agent de cristallisation comprend l'introduction d'un agent solide de cristallisation.

20. Procédé de la revendication 5 ou de la revendication 9, dans lequel l'introduction de l'agent de cristallisation solide comprend l'introduction de gel de silice dopé à l'agent de cristallisation.

21. Procédé de la revendication 5 ou de la revendication 9, dans lequel l'agent de cristallisation comprend la pulvérisation de l'agent de cristallisation en phase liquide.
